# EUROPEAN PATENT APPLICATION

(11) **EP 2 383 767 A1**
(43) Date of publication of application: **02.11.2011**
(21) Application number: 10161444.4
(22) Date of filing: 29.04.2010
(51) Int. Cl.: H01J 37/22, H01J 37/28, G01N 23/22, G01B 15/00, G02B 21/00

(54) **Method of imaging an object**

(71) Applicant: FEI COMPANY, Hillsboro, Oregon 97124-5793 (US)
(72) Inventor: Boughorbel, Faysal, 5623 LD, Eindhoven (NL); Kooijman, Cornelis, 5501 BC, Veldhoven (NL); Lich, Berend, 6002 AR, Weert (NL)
(74) Representative: Bakker, Hendrik

(57) **Abstract**

The invention relates to a method of acquiring two images with e.g. a Scanning Electron Microscope (SEM), and combine the images to form a combined image in which information of the surface layer or a subsurface layer is enhanced. To that end the probe parameters of the electron beam (110,120,140) of the SEM are different for the two images, one image is made at a lower energy than the other image. By reducing the mutual information between the two images, the combined image shows enhanced information of a subsurface layer.

## Description

The invention relates to a method of imaging an object, the object showing a surface, the method comprising:
- Acquiring a first image by scanning a probe with a first set of probe parameters over an area of interest of the object;
- Acquiring a second image by scanning a probe with a second set of probe parameters over an area of interest of the object;
- Each of the images comprising information of a layer close to the surface and information of a layer more removed from the surface; and
- Forming a combined image.

The invention further relates to an apparatus equipped to perform the method, and software to program an apparatus to perform the method.

This method is used when forming an image in a Scanning Electron Microscope (SEM) by averaging two or more images, or when combining for example a secondary electron image and a backscattered electron image.

In a SEM a sample is inspected by probing the sample with a finely focused beam of electrons. The beam of electrons with an energy of, for example, between 200 eV and 30keV is generated by an electron source. This beam of electrons is focused by lenses and deflected by deflectors, as a result of which a finely focused electron beam impinges on the sample. The deflectors can scan the beam over the sample, and where the beam hits the sample secondary radiation, such as secondary electrons, backscattered electrons, light and X-rays, emerge from the sample. By detecting these and correlating them with the position of the beam at the moment of detection, an image of the sample can be formed and displayed on a monitor. As an example, the intensity of a pixel in the image corresponds to the signal acquired for that pixel.

To improve the image, for example the signal-to-noise ratio of the image, it is known to average the information of several images. To that end several images are made of the same area of interest, each of the images with the identical beam current, beam energy and beam focus, so that ideally several identical images are made. These images are summed in an image memory, forming an averaged image with reduced signal-to-noise.

A SEM is often equipped with several types of detectors in order to provide as much information of the sample as possible. Such detectors may include secondary electron detectors (e.g. the well-known Everhart-Thornley detector), backscattered electron detectors (e.g. solid state detectors), photon detectors, X-ray detectors, etc. With these detectors information about, for example, topography, material composition, crystallographic information, etc., can be determined.

It is also known to form an image of a sample irradiated with an electron beam, in which the X-rays emerging from the sample are detected. Different X-ray energies are then often color coded. In this way different materials, having different K_{α}, K_{β} etc energies, can be distinguished.

It is well known that, with different beam energies, a secondary electron signal shows information close to the surface, while using a beam energy of several keV results in information of both close to the surface and deeper from the surface.

There is a need for a method offering supplemental information from a sample.

The invention intends to provide such a method.

To that end the method according to the invention is characterized in that the first set of probe parameters differs from the second set of probe parameters, as a result of which the ratio of information of the layer close to the surface and the layer more removed from the surface in the first image differs from the ratio of information of the layer close to the surface and the layer more removed from the surface in the second image, and the combined image either emphasizes the layer close to the surface or the layer more removed from the surface.

The method relies on the insight that detectable information, also known as secondary signals, originate from a so-named interaction volume in the sample. Inventors realized that, by changing the probe parameters, the interaction volume differs, and that his phenomenon can be used to gain supplemental information.

The interaction volume is often assumed to be a tear-shaped drop. The size and form of the tear depends on e.g. beam energy and material composition of the sample. The higher the energy of e.g. the electrons in the probe, the larger the size of the interaction volume; and the higher the average Z of the sample material, the smaller the interaction volume.

It is noted that the amount of detected signal not only depends on the volume where the secondary signals are generated, but also by the amount of material that the secondary signals must traverse before being detected: often part of the signal is absorbed by the sample material before the secondary signal can be detected.

When forming two images with two different beam parameters, such as two beams of electrons with different beam energies, the information in the two different images shows different depth information, due to the different beam parameters.

By then combining the images in such a way that e.g. mutual information is suppressed, or at least reduced, information of layers more removed from the surface is enhanced, and information of the layer close to the surface is reduced, and supplemental information is provided. In this way e.g. sub-surface images can be formed.

It is noted that other combination methods can be used, leading to other differentiation of the surface and sub-surface information in the combined image It is mentioned that imaging with two different beam parameters is known from US patent No. US6,683,934. This patent describes mammography in which two images are made: one using a first X-ray energy and a second with a second X-ray energy. The images are made by detecting transmitted X-rays with a pixilated detector.

The amount of X-rays transmitted depends on the thickness of the material and the attenuation factor of the material. As the attenuation factor itself is a function of the energy of the X-rays and the Z of the material, the two images together can be used to give information about both the thickness and the material composition (e.g. soft tissue versus calcified material).

The method of this patent differs from the method according to the invention in that it does not provide differentiation between surface and sub-surface information, in that it does not use secondary radiation, and in that it does not use a probe to scan the sample.

In an embodiment of the method of the invention the probe is a focused electron beam or a focused ion beam or a focused X-ray beam.

Instruments using a scanning focused electron beam or a scanning focused ion beam are well known. In these instruments the probe is focused by electric or magnetic fields and scanned by deflecting the beam with electric or magnetic fields. In the case of a focused X-ray beam it may be contemplated to moved the sample instead of the beam in order to scan the beam with respect to the sample.

In another embodiment of the method of the invention the combined image is formed by combining the first and the second image in such a way that, when compared to the first and the second image, the combined image shows enhanced information of the layer removed from the surface.

In a further embodiment of the method of the invention mutual information of the two images is estimated, and the combined image is formed using an algorithm that reduces said mutual information.

In another embodiment of the method of the invention the set of beam parameters shows at least a difference in beam energy, beam convergence angle, or the position of the focus of the beam with respect to the surface of the object.

In another embodiment of the method of the invention the sample shows a surface, and the beam parameter is the incidence angle of the beam with respect to the sample surface.

In another embodiment of the method of the invention the sample shows subsurface markers and/or labels.

This describes using the invention for a sample with labels and/or markers enabling identification of structures or positions in the sample.

In another embodiment of the method of the invention the images are formed by detecting secondary radiation from the group of secondary electrons, X-rays or photons in the range of visible or near-visible light.

In an aspect of the invention an apparatus for imaging a sample, the apparatus equipped with a beam source, means for focusing the beam on a sample and scanning means for scanning the beam over an area of interest of the sample, an image memory for storing at least two images, a controller for controlling beam parameters and a programmable processing unit for manipulating the images stored in the image memory, the processing unit programmed to combine the at least two images, is characterized in that the processing unit is programmed to estimate information mutual to the at least two images and suppress the estimated mutual information in the combined image.

By estimating the information that is mutual in both images, and suppress this in the combined images, the emphasis is laid on the differences in the images. These differences are the result of the differences of the interaction volume, and thus (in the case of e.g. different electron beam energies) the result of differences in depth. In this way a subsurface image can be made.

The invention is now elucidated on the hand of figures, in which corresponding reference numerals refer to indicate corresponding parts.

To that end:

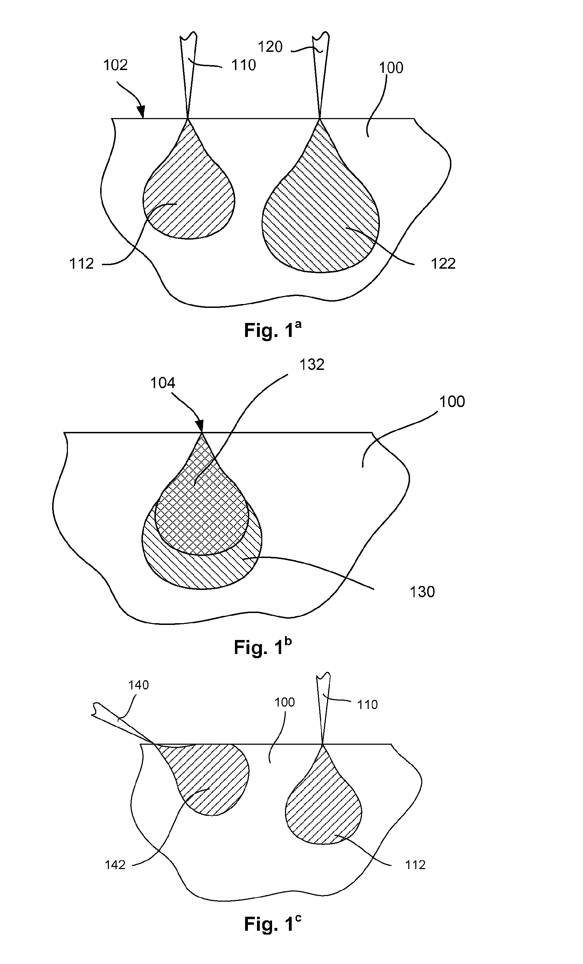

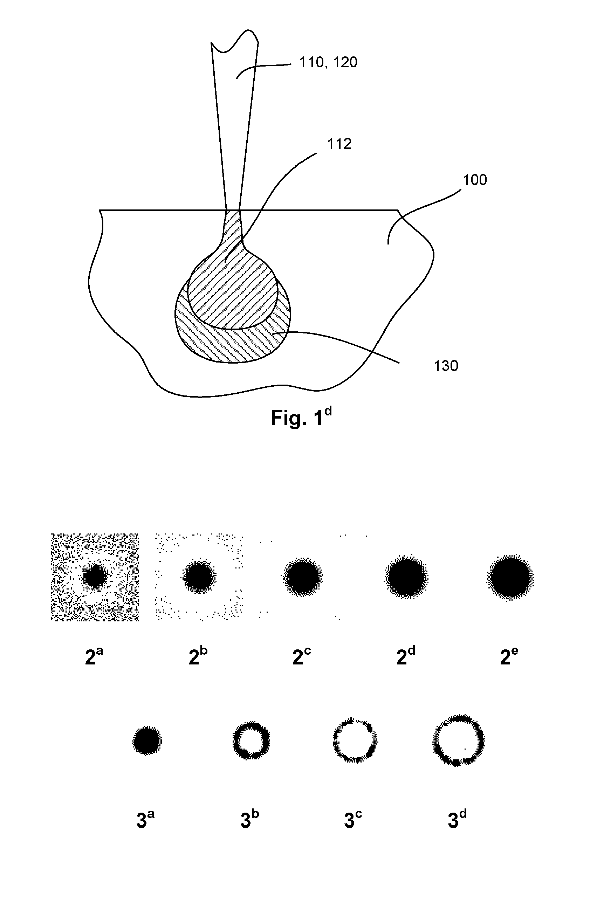

figure 1^{a} schematically shows two different interaction volumes, resulting from two beams with different beam parameters,
figure 1 ^{b} schematically shows the overlap of two different interaction volumes of figure 1a.
figure 1^{c} schematically shows another set of differing interaction volumes,
resulting from another difference in beam parameters.
figure 1^{d} schematically shows a sample that is irradiated with beams that are focused on a subsurface layer.
figure 2^{a}-2^{e} show the results of a Monte-Carlo simulation of a model of an electron probe interacting with the model of a vesicle at different beam energies,
figure 3^{a}-3^{d} show the images that are computed from the data of figures 2^{a}-2^{e} figure 4^{a}-4ⁿ show images acquired with a SEM of sections of part of a mouse brain comprising vesicles,
figure 5^{a}-5^{h} show images that are computed using the data of the images of figure 4,
figure 6^{a} and 6^{b} shows figure 5^{a} and figure 5^{h}, with marking of certain features.
figure 7 shows two images made of a series of images of a mitochondrion figure 8 shows two computed images based on the series associated with figure 7
figure 9 schematically shows the different steps used for forming a computed image, based on mutual information.
figure 10^{a} shows the scatterogram as formed in step 907 of the preceding.

Figure 1^{a} schematically shows two different interaction volumes, resulting from two beams with different beam parameters.

Figure 1^{a} show an object 100 that is irradiated with a first beam 110 and a second beam 120. These beams may be electron beams, but may also be other types of focused beams, such as proton beams, or neutron beams. Both beams are in this case focused on the surface 102 of the sample, but a focus at a subsurface layer may be used as well. Each of the beams has its own interaction volume, beam 110 interaction volume 112 and beam 120 interaction volume 122. As can be seen, interaction volume 122 is slightly larger than interaction volume 112, which can be the result of the electrons of beam 120 having a larger energy than the electrons of beam 110.

Figure 1 ^{b} schematically shows the overlap of the two interaction volumes shown in figure 1 that result when beam 110 and beam 120 impinge on the identical position 104. The two interaction volumes show a volume 132 mutual to both beams 110 and 120, and a volume exclusive to beam 120.

Figure 1^{c} schematically shows another set of differing interaction volumes, resulting from another difference in beam parameters.

In figure 1^{c} the angle with which the beam 110 and 140 impinge on the sample differ: beam 110 impinges perpendicular to the surface 102 of the sample, while beam 140 impinges under a slanted angle. Thereby the interaction volume of beam 140 is also closer to the surface. Overlaying the two interaction volumes results in a mutual portion and an exclusive portion, and thus in mutual information and exclusive information.

Figure 1^{d} schematically shows a sample that is irradiated with beams with different beam energies and that are focused on a subsurface layer.

It is noted that the interaction volumes are here represented by regular tear shaped volumes. When the sample is inhomogeneous in material, and specifically the Z of its material, this will distort the regular shape of the interaction volume. This is the case when observing, for example, semiconductor samples in which low-Z materials such as silicon are mixed with high-Z structures made of, for example, tungsten. However, especially for organic tissues and polymers the differences in atomic composition have hardly any effect on the size or shape of the interaction volume.

It is noted that in the above text the term mutual information is used. In other cases not the mutual information may be used to construct a combined image, but e.g. an algorithm based on linear dependent intensity (or otherwise a function of intensity) differences.

The differences in the information of the two interaction volumes can thus be used to emphasize subsurface or surface information.

Figure 2^{a}-2^{e} show the results of a computer simulation of images, using a model of a probe and a model of a sample (a vesicle), the probe having an energy of 1 kV, 1.25 kV, 1.5 kV, 1.75 kV and 2 kV respectively.

Figures 2^{a} - 2^{e} show the result of Monte-Carlo simulations of images of a vesicle. The beam profile is simulated for the different energies, as is the response of a structure (a model of a vesicle) to this probe. The obtained simulated images are used as input for computing the slices shown in figures 3^{a}-3^{d}.

Figures 3^{a}-3^{d} show the computed slices for the images acquired in figure 2^{a}-2^{e}, in which figure 3^{a} represents the image computed using the data of figure 2^{a} and 2^{b} (thus: a probe voltage of 1 kV and 1.25 kV), figure 3^{b} represents the image computed using the data of figure 2^{b} and 2^{c} (probe energy of 1.25 kV and 1.5 kV), etc.

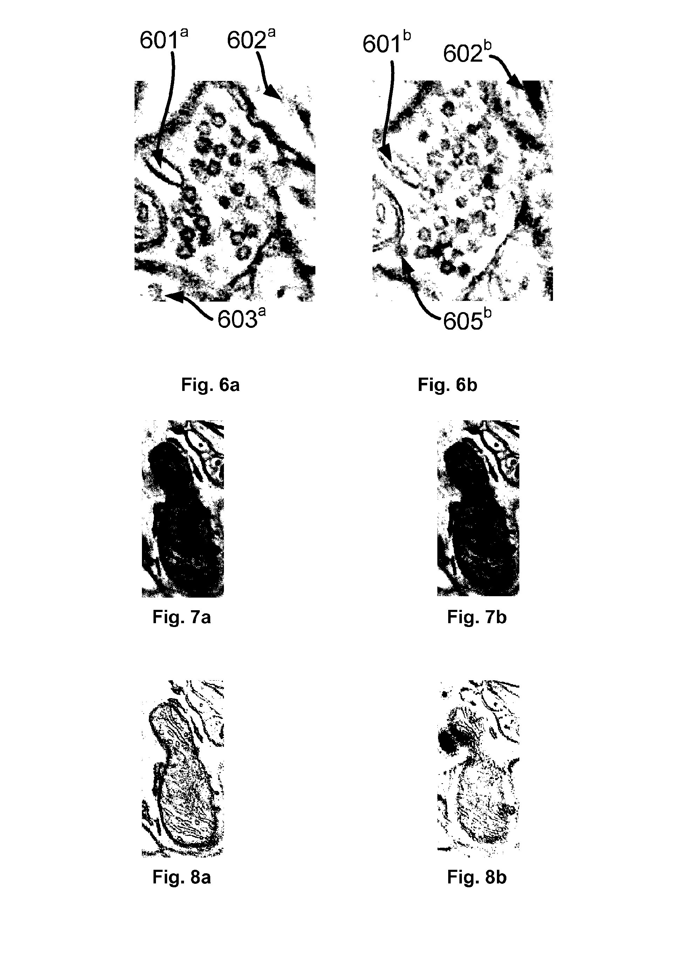

It is noted that the simulation is not based on a simple subtraction of the image data (although a subtraction could be used to make a computed image). The method used is explained in more detail in the text accompanying figures 7 and 8.

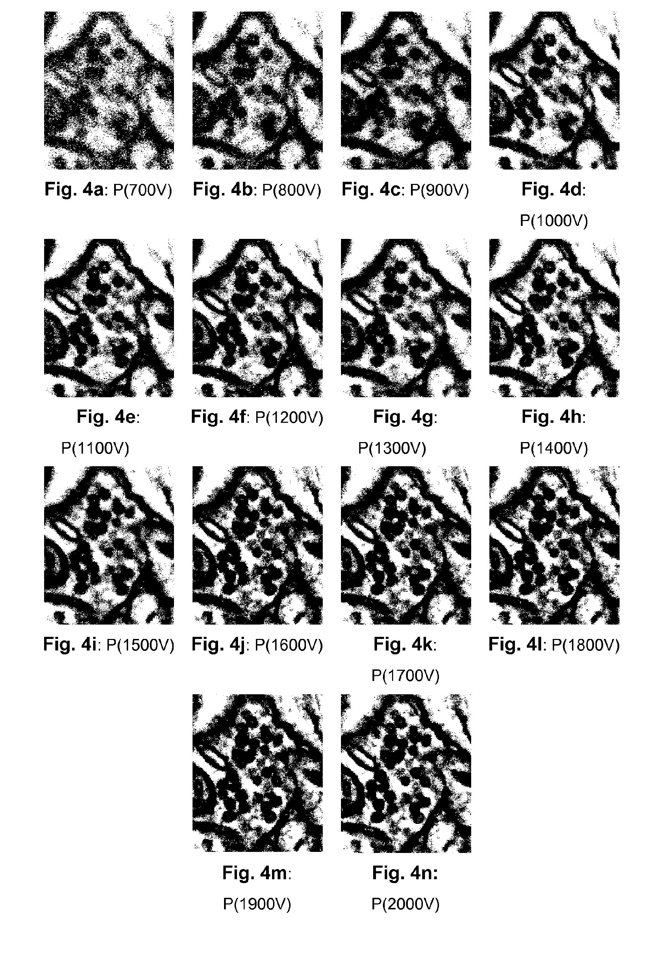

Figures 4^{a}-4ⁿ show a series of SEM images of a section of part of a mouse brain, comprising vesicles. The images are taken at different probe voltages, increasing from 700 V to 2000 V in steps of 100 V. As can be seen the field of view is identical for all images.

It is noted that the lower signal-to-noise ratio of figure 4³ compared to e.g. figure 4ⁿ is due to the lower sensitivity of the backscattered electron detector used for detecting the electrons. The detector used, a semiconductor device, shows a drastic decline in performance for electrons with an energy below 1 keV.

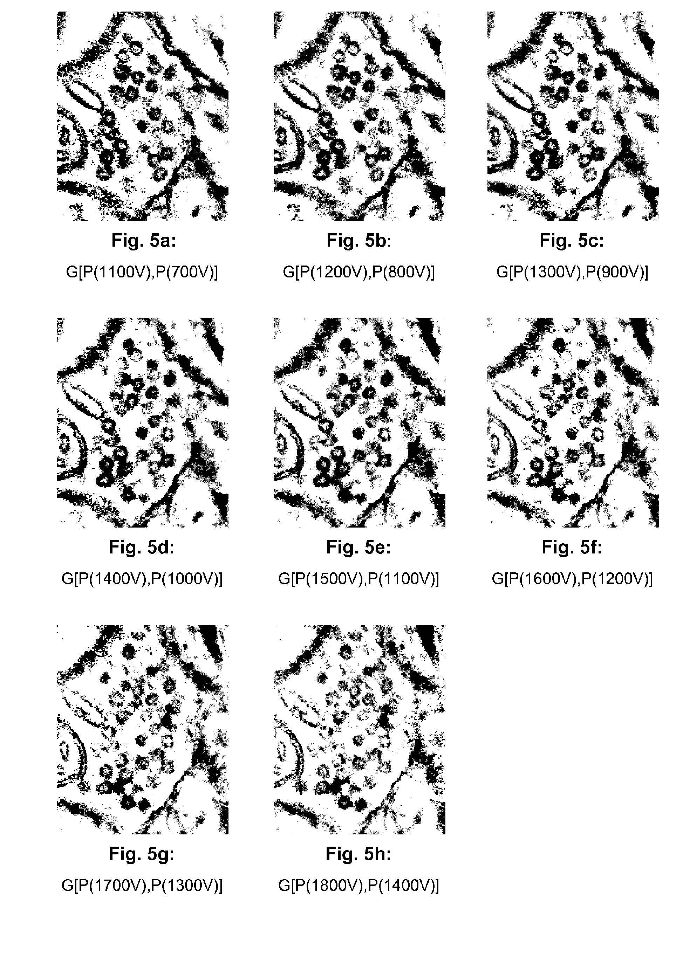

Figure 5^{a}-5^{h} show computed images, each image using the data of two images as shown in figure 4, at probe energies 400 V apart. In this figure 5^{a} shows an image using data of figure 4^{a} and 4^{e}, figure 5^{b} shows an image using data of figure 4 band 4^{f}, etc.

It is noted that the difference of 400 V between the low energy image and the high energy image is experimentally found, and may be different for other probe energies and/or other samples.

Figure 6 shows figure 5^{a} and figure 5^{h}, with marking of certain features.

As shown position 601^{a} (representing a position in a layer close to the surface) and position 601^{b} (representing a position from a deeper layer) differ in that at position 601^{b} an extra structure can be recognized that is not present at position 601^{a}. This extra structure is thus a subsurface structure. Similarly position 602^{a} and 602^{b} differ, from which can be concluded that the thick, contrast rich structure 602^{b} is not present close to the surface.

Structure 603^{a} has no pendant removed from the surface (in figure 6^{b}), while structure 604^{b} has no pendant close to the surface (in figure 6^{a}). Many such similarities and dissimilarities can be observed in the images, as well as in the images of intermediate probe voltages.

It is noted that for many algorithms the structures that extend in a direction along the axis of the probe, so typically structures that extend vertical to the surface are not imaged in the combined images (the computed images). This is explained as follows: a strictly vertical structure shows up in both images. When suppressing mutual information between the acquired images, a vertical structure is then suppressed. Also structures that are present in the uppermost layer show up in both images, albeit with a different contrast. Therefore this method alone may show artifacts, and/or does not show difference between very shallow structures close to the surface and structures that extend in a purely vertical direction. By combining this method with tomography, in which the beam is rocked with respect to the sample, this can be avoided and a true 3D reconstruction of the sample can be made.

Figure 7 shows two images made of a series of images of a mitochondrion, a first image taken at 700 V probe energy and a second taken at 2 kV probe energy. These two images are part of a series of images taken at 100 V interval. From this two images are computed.

Figure 8 shows two computed images based on the series associated with figure 7, one representing a layer close to the surface (based on an image with a probe energy of 700V and a probe energy of 900 V) and one more removed from the surface (using probe energies of 1600V and 2000V). Clearly the change in shape can be observed that is characteristic for slicing mitochondria at different distances of their top layer.

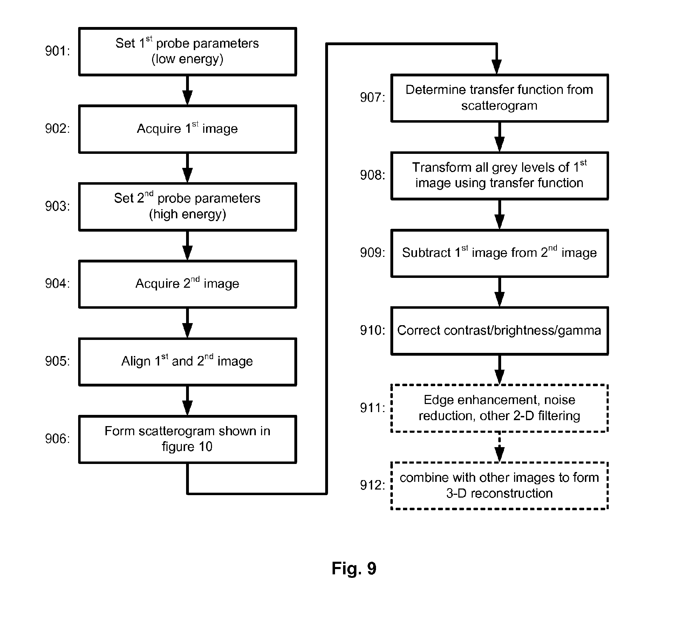

Figure 9 schematically shows the different steps used for forming a computed image, based on mutual information.

In step 901 the probe parameters are set to a first set of values, e.g. to a probe energy of 1 keV, and

In step 902 the first image is acquired by scanning the area of interest of the sample, and stored in a computer memory.

In step 903 the probe parameters are set to a second set of values, e.g. a probe energy that is 400 eV higher than used in step 901, and

In step 904 the second image is acquired by scanning the area of interest of the sample, and stored in a computer memory.

In step 905 the first and second image are aligned. Although the first and second image should comprise the same area, the images will not be perfectly aligned. Aligning can be done by correlation techniques, by aligning markers, or preferably by mutual Information-based registration. The latter is a high quality method for aligning images with large differences and multimodal datasets. All such aligning techniques are known to the person skilled in the art.

In step 906 for all coordinates in the two images the gray level of the pixel of the first image and the corresponding pixel of the second image are taken, and a point is put in a scatterogram in which the X-coordinate of said point is the gray level of the first image and the Y-coordinate is the grey level of the pixel in the second image.

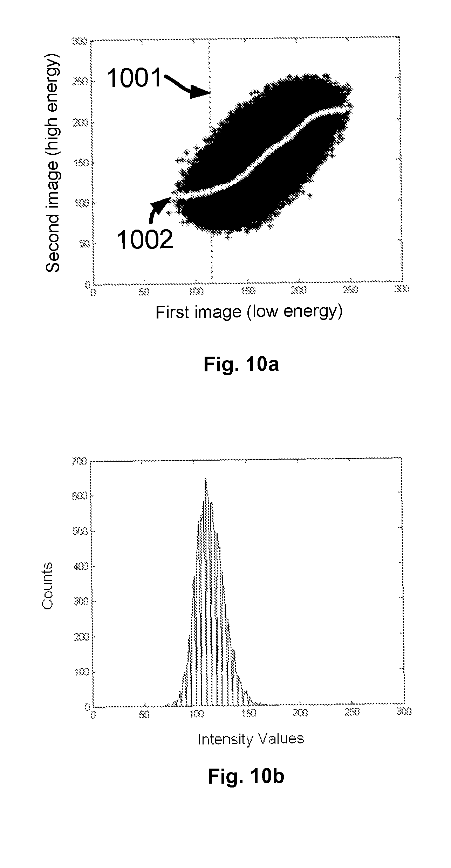

A typical result of step 906 is the scatterogram shown in figure 10.

In step 907 a transfer function is made using the data of the scatterogram, so that only one point is associated with each X-value. It is noted that the scatterogram starts with a one-to-many mapping, in which each X-value is associated with many Y-values. The resulting transfer function can be based on weighted average, or something as simple as 'the most occurring value'.

In step 908 for each pixel of the first image the grey level is changed according to the transfer function.

In step 909 the image formed in step 908 is subtracted from the second image and a combined image is formed.

In step 910 the contrast, brightness and e.g. y are corrected, so that an image using the full grey scale is formed.

In optional step 911 2-D filtering techniques may be used for edge enhancement, noise reduction, etc.

In optional step 912 the thus formed image may be combined with other images to form a 3-D set of images, either by combining it with other images at other probe settings, or by tomography, employing tilting of the sample with respect to the beam

It is noted that it is possible to change not only the first image based on the data of the scatterogram, but also to change the second image on this data. However the transfer function for the first and the second image should then be different.

Figure 10^{a} shows the scatterogram as formed in step 907 of the preceding. The white band 1002 in the middle of the cloud of scatter points is an artificial white band grouped around the highest values represents the weighted average of each vertical line.

Figure 10^{a} shows a vertical line 1001, corresponding with one grey level in the first image. Figure 10^{b} shows all gray levels in the second image associated with the grey level of vertical line 1001. For this curve the weighted average can be found, or another appropriate value. By repeating this for all grey levels of the first image, a transfer function is formed for transforming all grey levels in the first image to another grey level.

It is noted that it is not necessary to determine the transfer function for each pair of images, but that it is also possible to work with a typical transfer function that already proved to work with similar probes and samples.

It is further noted that this is one example of many how to form a combined image, and that many similar (or more remote) methods exist.

## Claims

1. A method of imaging an object (100), the object showing a surface, the method comprising:
• Acquiring a first image by scanning a probe (110) with a first set of probe parameters over an area of interest of the object;
• Acquiring at least a second image by scanning a probe (120) with a second set of probe parameters over an area of interest of the object;
• Each of the images comprising information of a layer close to the surface and information of a layer more removed from the surface; and
• Forming a combined image,
**Characterized in that**
The first set of probe parameters differs from the second set of probe parameters, as a result of which the ratio of information of the layer close to the surface and the layer more removed from the surface in the first image differs from the ratio of information of the layer close to the surface and the layer more removed from the surface in the second image, and the combined image either emphasizes the layer close to the surface or the layer more removed from the surface.

2. The method of claim 1 in which the probe is a focused electron beam or a focused ion beam or a focused X-ray beam.

3. The method of claim 1 or claim 2 in which the combined image is formed by combining the first and the second image in such a way that, when compared to the first and the second image, the combined image shows enhanced information of the layer removed from the surface.

4. The method of claim 3 in which mutual information of the two images is estimated, and the combined image is formed by an algorithm that reduces said mutual information.

5. The method of any of the preceding claims in which the set of beam parameters shows at least a difference in beam energy, beam convergence angle or the position of the focus of the beam with respect to the surface of the object.

6. The method of any of the preceding claims in which the sample shows a surface, and the beam parameter is the incidence angle of the beam with respect to the sample surface.

7. The method of any of the preceding claims in which the sample shows subsurface markers and/or labels.

8. The method of any of the preceding claims in which the images are formed by detecting secondary radiation from the group of secondary electrons, X-rays or photons in the range of visible or near-visible light.

9. Apparatus for imaging a sample, the apparatus equipped with a beam source, means for focusing the beam on a sample and scanning means for scanning the beam over an area of interest of the sample, an image memory for storing at least two images, a controller for controlling beam parameters and a programmable processing unit for manipulating the images stored in the image memory, the processing unit programmed to combine the at least two images is **characterized in that** the processing unit is programmed to estimate information mutual to the at least two images and suppress the estimated mutual information in the combined image.

10. Software carrier carrying code for programming the apparatus of claim 9 to perform any of the methods of claims 1-8.
